# EUROPÄISCHE PATENTSCHRIFT

(11) **EP 1 779 166 B1**
(45) Veröffentlichungstag und Bekanntmachung des Hinweises auf die Patenterteilung: **02.01.2013**
(21) Anmeldenummer: 05779356.4
(22) Anmeldetag: 28.07.2005
(51) Int. Cl.: G02B 13/00, H04N 5/225

(54) **KAMERAMODUL IM WAFERMASSSTAB, HIERAUF BASIERENDES ARRAY UND VERFAHREN ZU DESSEN HERSTELLUNG**
WAFER-SCALE CAMERA MODULE, ARRAY OF CAMERA MODULES, AND MANUFACTURING METHOD
MODULE DE CAMERA À ÉCHELLE DE TRANCHE, RÉSEAU DE MODULES DE CAMÉRAS ET PROCÉDÉ DE PRODUCTION

(30) Priorität: 28.07.2004 DE 102004036469
(43) Veröffentlichungstag der Anmeldung: 02.05.2007
(73) Patentinhaber: Fraunhofer-Gesellschaft zur Förderung der angewandten Forschung e.V., 80686 München (DE); Fresnel Optics GmbH, 99510 Apolda (DE)
(72) Erfinder: DUPARRE, Jacques, 07745 Jena (DE); DANNBERG, Peter, 07745 Jena (DE); SCHREIBER, Peter, 07749 Jena (DE); BITZER, Martin, 99510 Apolda (DE); BRÄUER, Andreas, 07646 Schlöben (DE)
(74) Vertreter: Pfenning, Meinig & Partner GbR
(86) Internationale Anmeldenummer: PCT/EP2005/008222
(87) Internationale Veröffentlichungsnummer: WO 2006/010622

(56) Entgegenhaltungen:
- EP-A- 1 239 519
- WO-A-02/069618
- WO-A-2004/027880
- PATENT ABSTRACTS OF JAPAN Bd. 1997, Nr. 05, 30. Mai 1997 (1997-05-30) -& JP 09 027606 A (FUJI FILM MICRO DEVICE KK; FUJI PHOTO FILM CO LTD), 28. Januar 1997 (1997-01-28)
- PATENT ABSTRACTS OF JAPAN Bd. 012, Nr. 285 (E-642), 4. August 1988 (1988-08-04) & JP 63 062267 A (NIPPON SHEET GLASS CO LTD), 18. März 1988 (1988-03-18)

## Beschreibung

Die Erfindung betrifft die Entwicklung kostengünstiger Kameramodule mit darin enthaltenen Objektiven mit minimaler Baulänge und hervorragenden optischen Eigenschaften gemäß dem Oberbegriff des Anspruchs 1. Hierdurch wird ermöglicht, dass derartige Kameramodule in Mobiltelefonen oder Kleincomputern, wie PDAs (Personal Digital Assistant) eingesetzt werden können.

Von den Herstellern von Mobiltelefonen und tragbaren Minicomputern wird zunehmend die Verkleinerung einzusetzender Digitalkameras gefordert. Um die Miniaturisierung der Elektronik nicht aufzuhalten, müssen dementsprechend die abbildenden Optiken immer kürzere Ausmaße aufweisen. Somit ist es wünschenswert, für gegebenes Gesichtsfeld und Bildfeld die minimal mögliche Baulänge bei gleichbleibender optischer Abbildungsqualität zu erreichen.

Bei aus dem Stand der Technik bekannten Montagevarianten werden derzeit die Komponenten der Optiken einzeln gefertigt, zu Objektiven zusammengefügt und einzeln relativ zu den bildgebenden Optoelektroniken, z.B. CCD- oder CMOS-Matrizen, positioniert. Dies ist ein hoher Montageaufwand, der zu hohen Kosten und nicht reproduzierbaren Dejustierungen und damit Ausschuss führt.

Die US 4,348,081 beschreibt ein Projektionsobjektiv für das Schirmbild einer Kathodenstrahlröhre, wobei das Objektiv ein zur Korrektur blendenabhängiger Abberation dienendes Element, ein bikonvexes Element und ein als Bildfeldebner dienendes Element aufweist. Eine Miniaturisierung ist in diesem Fall jedoch nicht gegeben, da im Bereich der Kathodenstrahlröhren dies kein wesentliches Erfordernis darstellt.

Die EP 1239519 zeigt ein Kameramodul aus einem miniaturisierten Objektiv mit einer Trägerstruktur aus Borsilikatglas mit gesichtsfeldseitig angeordneter bildgebender Optoelektronik sowie einer monolithischen, asphärischen Linesenplatte aus einem polymeren Werkstoff.

In der WO 2002/069618 A wird ein Kameramodul mit einer Systemapertur und zwei Linsen gezeigt. Weitere Kameramodule sind beispielsweise der WO 2004/027880 A entnehmbar.

Ausgehend hiervon war es Aufgabe der vorliegenden Erfindung, ein Kameramodul mit einem miniaturisierten Objektiv bereitzustellen, das im Wafermaßstab herstellbar ist und so den Montagaufwand und die Herstellungskosten für die Kameramodule erheblich reduziert.

Diese Aufgabe wird durch das Kameramodul mit den Merkmalen des Anspruchs 1, das Array aus derartigen Kameramodulen mit den Merkmalen des Anspruchs 12 sowie das Verfahren zur Herstellung eines Kameramoduls mit den Merkmalen des Anspruchs 14 gelöst. Die Verwendung der erfindungsgemäßen Kameramodule wird in Anspruch 22 beschrieben. Die weiteren abhän- gigen Ansprüche zeigen vorteilhafte Weiterbildungen auf.

Erfindungsgemäß wird ein Kameramodul gemäss Anspruch 1 bereitgestellt.

Genauer gesagt umfasst das System zwei monolithische, asphärisch plankonvexe, gesichtsfeldseitigen Linsen und eine asphärisch plankonkave, bildfeldseitige Linse (3). Das System ist bildseitig nicht telezentrisch ausgelegt.

Der IR-Sperrfilter besteht aus einem dielektrischen Schichtsystem, das aus mechanisch-thermischen Gründen vorzuziehen ist. Der IR-Sperrfilter kann dabei so ausgelegt sein, dass selbst für ein großes Spektrum von Einfallswinkeln durch mangelnde Telezentrie der Abbildung die Funktion erfüllt ist. Auch dieser wird im Wafer-Maßstab hergestellt und an entsprechender Stelle in den Optik-Komponenten-Stapel eingebracht.

Weiterhin ist zwischen zwei Linsenplatten ein abstandsdefinierendes Element in Form einer nicht-transparenten Polymerplatte mit einer die Systemapertur bildenden kegelförmigen Ausnehmung angeordnet. Diese fungiert so als Lichtschutztrichter zur Einschränkung des Gesichtsfeldes der Optik und damit zur Reduktion von Streulicht und wirkt aufgrund ihrer Dicke als Feldblende.

Diese Erfindung bringt den Vorteil mit sich, dass mikrooptische Technologien, wie UV-Replikation oder Heißprägen in Plastik, welche die hochgenaue und kostengünstige Herstellung vieler gleichartiger optischer Elemente parallel auf einem Substrat ermöglichen, eingesetzt werden können. Prägewerkzeuge werden durch galvanische Abformung von Präzisions-Diamant-gedrehten Masterstrukturen generiert. Die Montage der zum Aufbau hochwertiger Objektive der nötigen mehreren optischen Komponenten geschieht im Wafer-Maßstab. Durch die Monatage im Wafer-Maßstab wird es erstmals finanziell sinnvoll, mehr als zwei optische Elemente für derartige Objektive einzusetzen. Durch die vorliegende Erfindung kann so verglichen mit auf der klassischen Weise hergestellten Objektiven eine herausragende optische Qualität der optischen Abbildung erreicht werden, die gleichzeitig mit geringeren Kosten verbunden ist.

Als bildgebende Optoelektronik wird vorzugsweise ein CMOS-Sensor eingesetzt, der abgedünnt und rückseitig beleuchtet ist. Hierdurch muss das Objektiv nicht zwingend telezentrisch arbeiten. Durch die Anpassung des Objektivdesigns an einen CMOS-Sensor entstehen neue Design-Freiheitsgrade, welche eine drastische Verkürzung der Optiken ermöglichen. Hohe Einfallswinkel auf den bildgebenden Sensor, d.h. bildseitiger Hauptstrahlwinkel, sind bei Nutzung abgedünnter und durch die Rückseite beleuchteter CMOS-Sensoren nicht problematisch, da hier weniger Abschattungseffekte der aktiven Pixel durch Leiterbahnen und Elektrodenstrukturen auftreten bzw. sich die dünnen Farbfilter sehr nahe vor den aktiven Pixelgebieten befinden und so ein geringes Risiko für Farb-Übersprechen besteht. Der Verzicht auf bildseitige Telezentrie erlaubt, verglichen mit üblichen Objektiven, einen unkonventionellen Strahlengang und damit alleine aufgrund der Geometrie eine deutliche Reduktion der Systemlänge.

Als bildgebende Optoelektronik kann in einer weiteren bevorzugten Variante auch ein CCD-Sensor im Kameramodul verwendet werden.

Hinsichtlich der Linsenplatte müssen diese an eine Wafer-Maßstabmontage angepasst sein, d.h. es dürfen keine extremen Menisken eingesetzt werden. Die Kanten- und Zentrumsdicken der Linsen müssen in für das Heißprägen vertretbaren Größenordnungen eingestellt werden. Die einzelnen Linsenplatten besitzen eine plankonvexe und/oder plankonkave Oberfläche. Dies vereinfacht die Herstellung der einzelnen Linsenplatten. Absweichend von der Erfindung kann im allgemeinen jedoch auch von bikonkaven und/oder bikonvexen oder konvexkonkaven bzw. konkavkonvexen Linsenplatten ausgegangen werden, um Anforderungen des Optikdesigns und der Baulänge gerecht zu werden. Dadurch erhöht sich jedoch der Montageaufwand der vorder- und rückseitigen Werkzeuge.

Als Polymermaterialien für die Herstellung der Linsenplatten kommen Polymethylmetacrylat (PMMA), Polycarbonat, Polystyrol, Cycloolefin-Polymer (COP), Cycloolefin-Copolymer (COC) oder andere Polymeren auf Polycycloolefin-Basis, zum Beispiel Zeonex, bevorzugt zur Anwendung. So zeichnet sich PMMA durch seine geringe Dispersion aus, auf der anderen Seite ist es thermisch oder hinsichtlich Luftfeuchtigkeit nicht sehr stabil. Polycarbonat hingegen ist hoch dispersiv, dahingegen mechanisch, thermisch und hinsichtlich der Luftfeuchtigkeit sehr stabil. Für eine Achromatisierung bieten sich Kombinationen von kron- bzw. schwerflintartigen Polymeren an.

Das Objektiv weist mindestens zwei Linsenplatten auf. Dabei ist es besonders bevorzugt, dass die mindestens zwei Linsenplatten unterschiedliche Dispersionscharakteristika aufweisen und damit die Achromatisierung des Objektivs ein gestellt ist.

Vorzugsweise ist mindestens eine der Linsenplatten als Bildfeld ebnendes Element ausgebildet, woraus eine deutlich verbesserte optische Abbildungsqualität über das gesamte Gesichtsfeld des Objektivs resultiert. Diese befindet sich direkt vor der Bildebene.

Ein spezielles Filterdesign ist erforderlich, um der großen Einfallswinkelbandbreite und dem Polymerwerkstoff der mindestens einen Linsenplatte als Superstrat Rechnung zu tragen und eine minimale Verschiebung der Bandkante abhängig zum Einfallswinkel zu erreichen.

Als Trägerstruktur für die bildfeldseitig angeordnete bildgebende Optoelektronik und den gesichtsfeldseitig angeordneten IR-Sperrfilter werden solche aus Quarzglas und/oder Pyrex verwendet. Diese bringen den Vorteil mit sich, dass sie die Erfordernisse der Herstellungs- und Bondingprozesse hinsichtlich eines großen Temperaturintervalls für die Verbindung des Sensors zum Träger erfüllen.

Das erfindungsgemäße Kameramodul ist so konzipiert, dass die Baulänge des Kameramoduls von der Bildebene bis zur ersten Oberfläche des Kameramoduls im Bereich von 1 mm bis 10 mm, besonders bevorzugt von 3 mm bis 5 mm liegt.

Erfindungsgemäß wird ebenso ein Array aus erfindungsgemäßen Kameramodulen bereitgestellt, bei dem eine Vielzahl von Kameramodulen auf einer einzigen Trägerstruktur angeordnet ist. Hierbei können von 2 bis mehrere tausend Kameramodule auf der Trägerstruktur angeordnet sein.

Ebenso wird erfindungsgemäß ein Verfahren zur Herstellung eines erfindungsgemäßen Kameramoduls bereitgestellt, bei dem im Wafermaßstab durch Heißprägung oder UV-Replikation eine Linsenplatte hergestellt wird. Weiterhin wird auf einer Trägerstruktur bildfeldseitig eine bildgebende Optoelektronik und gesichtsfeldseitig ein IR-Sperrfilter in Wafer-Technologie aufgebracht. Die Linsenplatte wird mit einem UV- oder thermisch härtbaren Klebstoff gesichtsfeldseitig mit dem IR-Sperrfilter verbunden und die einzelnen Kameramodule werden mittels Sägeblättern separiert.

Der Prozess der Separierung der einzelnen Kameramodule kann im Rahmen der Erfindung je nach Anwendung an verschiedenen Stellen der Prozesskette angesetzt werden. Höchste Integration wird erreicht, wenn auch die bildgebende Optoelektronik und die nötige Leiterplatte im Wafermaßstab mit dem Optikwafer verbunden werden und so die Vereinzelung erst nach der Montage aller für eine Digitalkamera nötigen Komponenten geschieht. Auf diese Weise ist eine Justierung der Elemente eines Moduls nicht modulweise, damit makroskopisch und nur mit begrenzter Genauigkeit durchführbar, sondern für eine große Gruppe von Modulen auf einem Wafer mit einem Justageschritt und lithographischer Genauigkeit durch so erzeugte Justierstrukturen auf den Wafern.

Vorzugsweise wird das abstanddefinierende Element durch Heißprägen, Spritzgießen oder Ausbohren aus einer nicht-transparenten Polymerplatte hergestellt.

Das erfindungsgemässe Verfahren sieht vor, dass das abstanddefinierende Element mit einem UV- oder thermisch härtbaren Klebstoff mit den Linsenplatten verklebt wird.

Die Montage des Waferstapels kann unter Zuhilfenahme von Justierstrukturen auf den einzelnen Wafern durchgeführt werden. Hierdurch kann die Präzision bei der Herstellung deutlich erhöht werden, wobei gleichzeitig der Herstellungsaufwand durch gleichzeitige Justage vieler Kameramodule reduziert wird Die erfindungsgemäßen Kameramodule finden insbesondere Anwendung bei der Herstellung von Mobiltelefonen oder tragbaren Minicomputern (personal digital assistant, PDA).

Im Folgenden wird eine bevorzugte Ausführungsform des erfindungsgemäßen Kameramoduls anhand dessen Aufbau beschrieben.

Die refraktiven, asphärischen, optischen Komponenten im Wafermaßstab bilden das abbildende optische System. Diese bestehen aus drei heißgeprägten Linsenplatten aus PMMA und einer Abstands- und Systemapertur definierenden, nicht-transparenten Polymerplatte mit kegelförmigen Löchern. Die optischen Komponenten sind dabei vorzugsweise selbstjustierend oder durch Justiermarken zueinander im Wafermaßstab alignierbar miteinander verbunden. Hierunter ist zu verstehen, dass die tatsächlichen optisch relevanten Linsenflächen entsprechend in der Tiefe in den Linsenplatten versenkt bzw. versetzt sind. Weiterhin weist das Kameramodul einen Träger aus Quarzglas oder Pyrex auf, an dessen Bildfeldseite die bildgebende Optoelektronik, z. B. ein CMOS-Sensor, angeordnet ist. Ein Träger aus Polymermaterial ist hier wenig vorteilhaft, da dessen thermischer Ausdehnungskoeffizient zu groß ist, um an dem des aus Silizium bestehenden CMOS-Sensors angepasst zu sein, was dessen Zerstörung zur Folge hätte. Weiterhin weist das erfindungsgemäße Kameramodul einen IR-Sperrfilter als dielektrisches Schichtsystem auf, das gesichtsfeldseitig auf die Trägerstruktur aufgebracht ist. Hierbei ist ein spezielles Filterdesign erforderlich, um der großen Einfallswinkelbandbreite und den Polymerwerkstoffen für die Linsenplatten als Substrat Rechnung zu tragen und eine minimale Verschiebung der Bandkante abhängig vom Einfallswinkel zu erreichen. Die Linsenformen müssen dabei an eine Wafermaßstab-Montage angepasst sein, d.h. extreme Menisken müssen vermieden werden. Die Kanten- und Zentrumsdicken der Linsen müssen in für das Heißprägen vertretbaren Größenordnungen eingestellt werden. Weiterhin ist es vorteilhaft, einen Scherpunkt beim Teilen des Optowafers entstehenden seitlichen Sägeflächen durchzuführen, um das Streulicht zu minimieren. Weiterhin können Beschichtungen zur Entspiegelung im Wafermaßstab aufgebracht werden. Dabei sollte die Beschichtung der gesichtsfeldseitigen Oberfläche vorteilhafterweise mit einer feuchtigkeitsabweisenden und kratzfesten Beschichtung erfolgen. Planare, innerhalb des Objektivs liegende Flächen können z.B. mit Mottenaugenstrukturen zur Entspiegelung versehen werden. Die Erzeugung dieser Strukturen ist einfach durch die Wahl des entsprechenden Prägewerkzeugs für die Rückseite eines Linsenwafers während der Abformung der Linsenstrukturen auf der Vorderseite zu ermöglichen. Eine Entspiegelung der Linsenstrukturen selbst kann bevorzugt durch dielektrische Schichtsysteme erfolgen. Es ist aber auch eine Strukturierung der gekrümmten Oberflächen der Linsen mit Mottenaugenstrukturen denkbar.

Die Anordnung der Linsen in dem aus dem Waferstapel ausgesägten Modul muss weiterhin gewährleisten, dass Licht, welches von Quellen außerhalb des Gesichtsfeldes in die Systemapertur einfällt, nicht durch Reflektion oder Brechungen an optischen Grenzflächen außerhalb der genutzten Linsenöffnung wieder auf den Bildempfänger gelangt. Dies hätte eine Kontrastminderung oder Generierung von Geisterbildern zur Folge. Aus Streulichtsimulation folgt, dass speziell die Übergänge zwischen den Linsen, welche zur Definition des Linsenabstands dienen, in dieser Beziehung kritisch sind. Eine Vergrößerung der freien Öffnung an diesen Übergängen ist daher entscheidend, dass selbst Licht, welches unter den größtmöglichen Einfallswinkel in die Systemöffnung einfällt, nicht reflektiert oder wieder zum Sensor hingebrochen wird.

Anhand der nachfolgenden Figuren und Beispiele soll der erfindungsgemäße Gegenstand näher beschrieben werden, ohne diesen auf die hier genannten speziellen Ausführungsbeispiele zu beschränken.
Fig. 1 zeigt eine schematische Darstellung eines Arrays aus Kameramodulen.
Fig. 2 zeigt in einer schematischen Darstellung den Aufbau eines Kameramoduls.
Fig. 3 zeigt ein Beispiel einer Prozesskette für die Herstellung der Kameramodule.
Fig. 4 zeigt in perspektivischer Darstellung den Aufbau eines erfindungsgemäßen Kameramoduls.
Fig. 5 zeigt eine schematische Darstellung der optischen Anordnung in dem erfindungsgemäßen Kameramodul.
Fig. 6 zeigt die Transmissionskurve eines erfindungsgemäß eingesetzten IR-Sperrfilters.
Fig. 7 zeigt in einem Diagramm die RMS-Spottradien eines erfindungsgemäßen Kameramoduls.
Fig. 8 zeigt die Modulationsübertragungsfunktion (MTF) eines erfindungsgemäßen Kameramoduls, aufgetragen über der Bildfeldkoordinate (A) bzw. der Ortsfrequenz (B).
Fig. 9a zeigt am Diagramm die Bildfeldwölbung und Verzeichnung eines erfindungsgemäßen Kameramoduls.
Fig. 9b zeigt in einem Diagramm den Hauptstrahlwinkel im Bildraum aufgetragen als Funktion der Bildfeldkoordinate eines erfindungsgemäßen Kameramoduls.
Fig. 10 zeigt eine Schnittdarstellung am Übergang zweier Linsenplatten eines erfindungsgemäßen Kameramoduls.

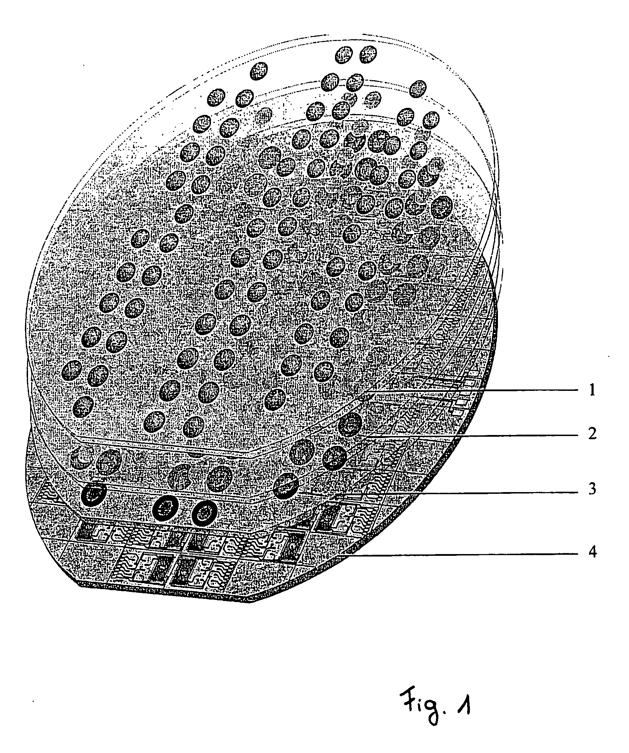

Fig. 1 zeigt die Darstellung der prinzipiellen Herstellung miniaturisierter Objektive im Wafermaßstab anhand der Anordnung einer bevorzugten Ausführungsvariante. Drei in Polymer heißgeprägte Linsenplatten 1, 2 und 3 formen den Optikwaferstapel. Der absorbierende Abstandshalter 5 ist hier nicht dargestellt. Eine Quarz-Glas-Platte 4 welche auf ihrer Vorderseite den IR-Sperrfilter und auf der Rückseite die bildwandelnde Optoelektronik, hier ein abgedünnter und rückseitig beleuchteter CMOS-Sensor, trägt, wird mit dem Optikwaferstapel verbunden, um das Array von Kameramodulen im Wafermaßstab zu bilden.

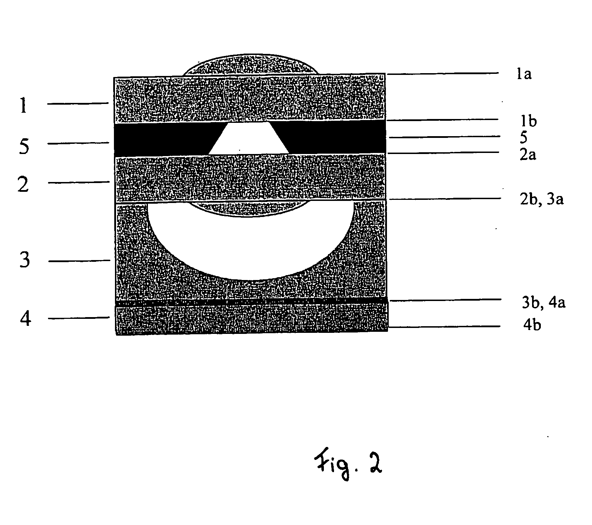

Fig. 2 zeigt ein vereinzeltes Kameramodul bestehend aus Linsen in Polymer 1, 2und 3 mit planen 1b, 2a, 3b und convexen 1a, 2b, bzw. konkaven 3a Flächen, IR-Sperrfilter 4a auf der Vorderseite des Quarz-Glas-Substrates 4 und abgedünntem und rückseitig beleuchtetem CMOS-Sensor auf der Rückseite 4b, absorbierende, mit kegelförmiger Öffnung die Systemapertur bildende und als Abstandshalter zwischen den Flächen 2b und 3a dienende Polymerplatte 5.

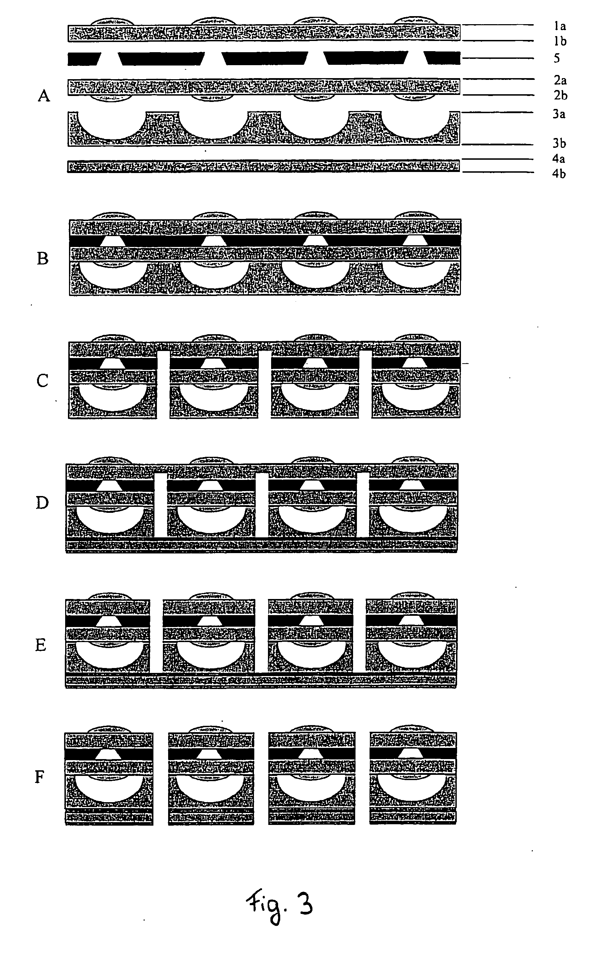

Fig. 3 zeigt einen Vorschlag für eine Prozesskette zur Herstellung von miniaturisierten digitalen Kameras im Wafermaßstab anhand der oben beschriebenen Ausführungsvariante:

Fig. 3A: Herstellung der Linsenplatten 1, 2 und 3 mit planen 1b, 2a, 3b und convexen 1a, 2b, bzw. konkaven Flächen durch Heißprägen in Polymer. Generierung des IR-Sperrfilters auf der Vorderseite des Quarz-Glas-Substrates 4a und nachfolgend Applikation des abgedünnten und rückseitig zu beleuchtenden CMOS-Sensors auf der Rückseite 4b. Erzeugung der absorbierenden, mit kegelförmiger Öffnung die Systemapertur der einzelnen Module bildenden und als Abstandhalter zwischen den Flächen 2b und 3a dienenden Polymerplatte 5 durch Heißprägen, Spritzgießen oder Ausbohren aus Platten der richtigen Dicke.

Fig. 3B: Zusammenführung und Justage der einzelnen Polymer-Komponentenwafer, Verklebung mit UV- oder thermisch-härtbarem Kleber.

Fig. 3C: Rückseitiges Vorsägen des Polymerwaferstapels mit an Polymer angepassten Sägeblättern.

Fig. 3D: Zusammenführung, Justage und UV- oder thermisch-härtbare Verklebung des Polymerwaferstapels mit der den IR-Sperrfilter und den CMOS-Sensor tragenden Quarz-Glas-Platte.

Fig. 3E: Durchtrennung der übrig gebliebenen tragenden Polymerstrukturen des Polymerwaferstapels mit geeigneten Sägeblättern.

Fig. 3F: Durchtrennung der Quarz-Glas-Platte mit angepasstem Sägeblatt. Es resultiert die Vereinzelung der Kameramodule.

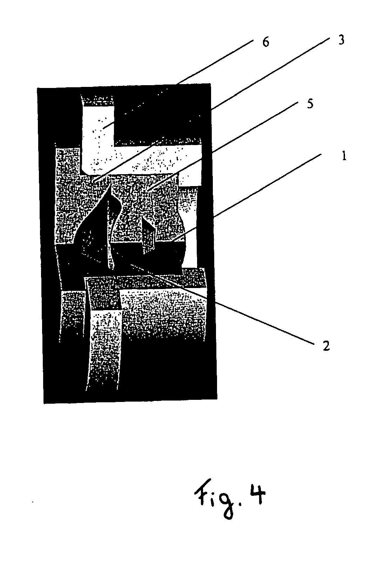

Fig. 4 zeigt die Stapelung der einzelnen Polymer-Komponenten eines Kameramoduls zu einem Sandwich mit integrierter Abstandhalterung. Linsenplatten 1, 2 und 3 sowie schwarzer Platte 5 zur Definition der Systemapertur und des Abstandes der Linsen 1 und 2. Die Abstanddefinition zwischen den Linsen 2 und 3 wird über die Tiefe bzw. Form der Linsenplatten 2 und 3 bestimmt. In dieser Ausführungsvariante können auch die Komponenten der einzelnen Module vor der Montage vereinzelt werden und durch die Form des sie aufnehmenden Zylinders 6 in die richtige Zentrierung gebracht werden.

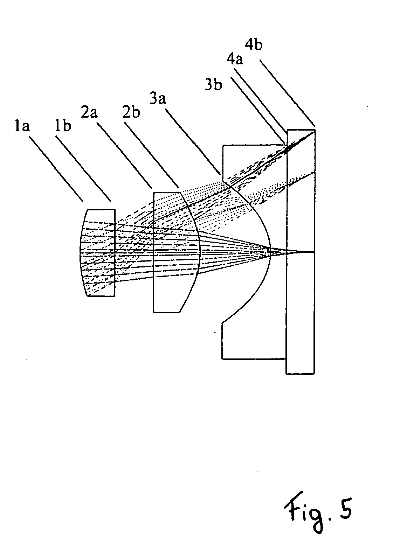

Fig. 5 zeigt einen Schnitt durch die rotationssymmetrische optische Anordnung. Der Durchmesser des Bildkreises ist 4.56 mm, die Systemlänge von der ersten Linsenfläche 1a bis zur Bildebene 4b ist 4.32 mm. Die repräsentierten Feldwinkel sind 0°, 25° und 35°.

Dargestellt sind die Linsen in PMMA 1, 2 und 3 mit planen 1b, 2a, 3b und konvexen 1a, 2b, bzw. konkaven 3a Flächen, IR-Sperrfilter auf der Vorderseite des Quarz-Glas-Substrates 4a und abgedünntem und rückseitig beleuchtetem CMOS-Sensor auf der Rückseite 4b.

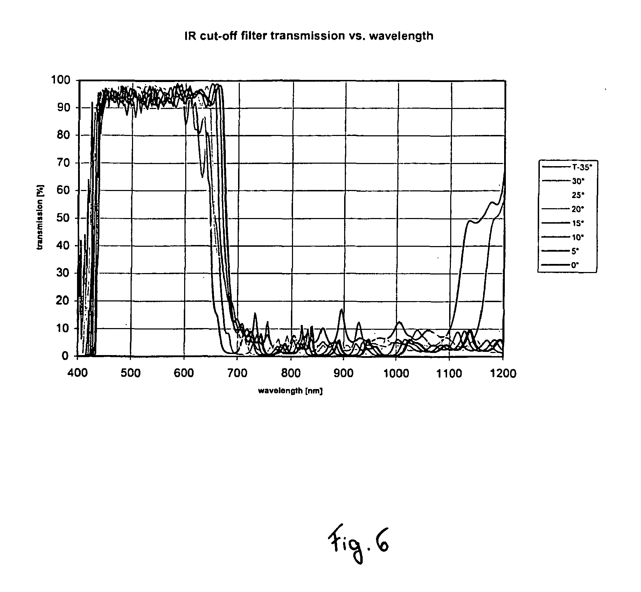

Fig. 6 zeigt eine Transmissionskurve des speziell angepassten IR-Sperrfilters mit dem Einfallswinkel in PMMA als Parameter. Aufgetragen ist die Transmission des Filters als Funktion der Wellenlänge bei verschiedenen Einfallswinkeln. Die Bandkante liegt bei ca. 650 nm (50% Transmission). Die Bandkantenverschiebung mit dem Einfallswinkel konnte durch ein spezielles Filterdesign reduziert werden.

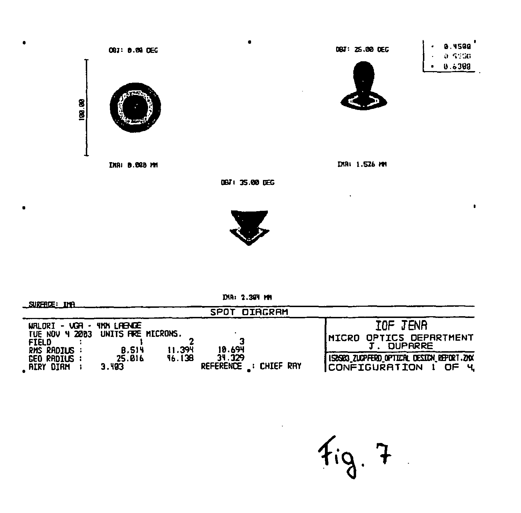

Fig. 7 zeigt ein Diagramm, das belegt, dass von dem System Spots mit über das Bildfeld durchschnittlichen RMS-Spotradien von 10µm erzeugt werden. Dargestellt stellt sind die polychromatischen Punktbilder des erfindungsgemäßen Objektives unter drei verschiedenen Einfallswinkeln für 0°, 25° und 35°.

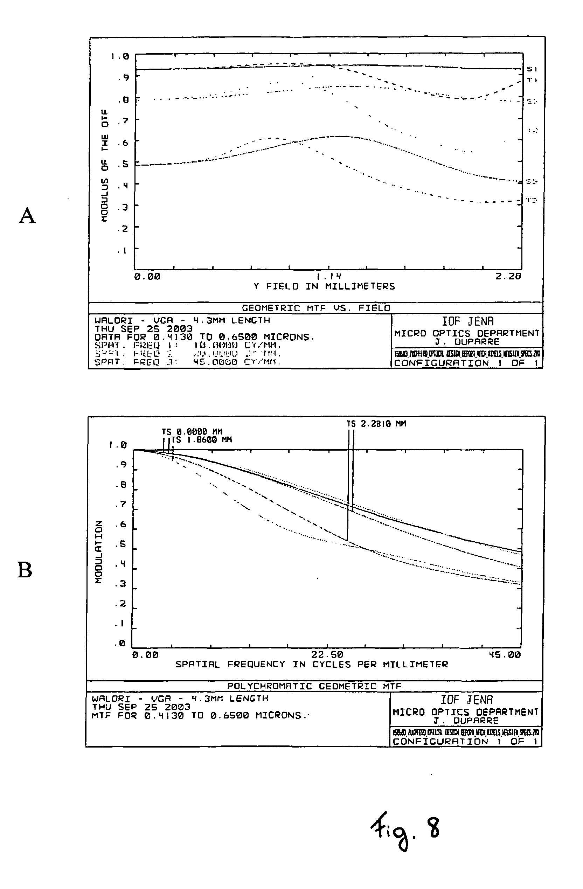

Fig. 8A zeigt die Modulationsübertragungsfunktion (MTF) der beschriebenen Ausführungsvariante aufgetragen über der Bildfeldkoordinate, jeweils für die tangentiale und für die sagitale Bildrichtung. Parameter sind drei betrachtete Ortsfrequenzen. Es kann nur eine marginale Verschlechterung der Auflösung über das Bildfeld abgelesen werden.

Fig. 8B zeigt die Modulationsübertragungsfunktion (MTF) der beschriebenen Ausführungsvariante aufgetragen über der Ortsfrequenz, jeweils für die tangentiale und für die sagitale Bildrichtung. Parameter sind drei betrachtete Bildfeldkoordinaten. Es kann ein tolerierbarer Abfall des Abbildungskontrastes mit wachsender Feinheit von Bilddetails abgelesen werden.

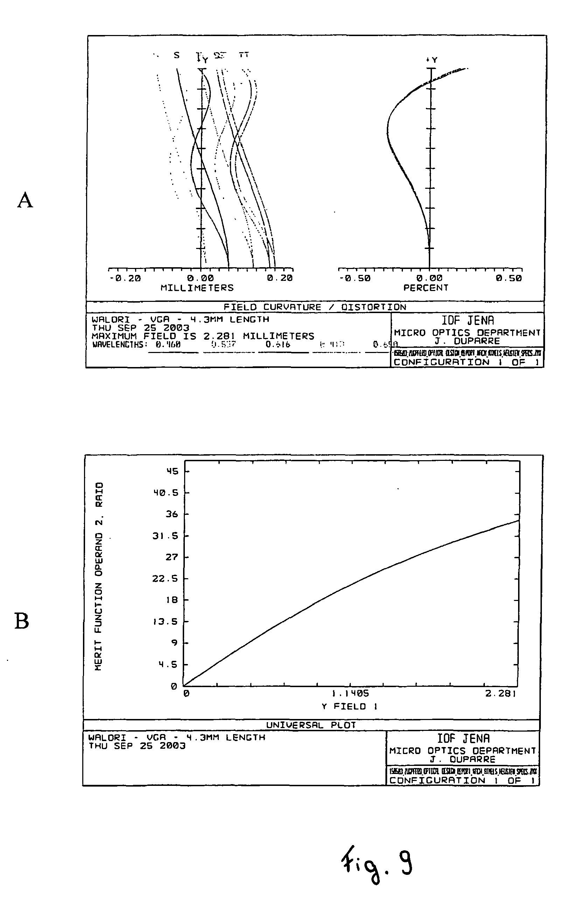

Fig. 9A zeigt, dass die Bildfeldwölbung (Verschlechterung der Auflösung mit wachsender Bildfeldkoordinate) und Verzeichnung (Änderung des Abbildungsmaßstabes als Funtion der Bildhöhe) der beschriebenen Ausführungsvariante minimal sind. Dargestellt sind die Kurven für verschiedene Wellenlängen und für die tangentiale und sagitale Bildrichtung.

Fig. 9B zeigt den Hauptstrahlwinkel im Bildraum aufgetragen als Funktion der Bildfeldkoordinate. Das System ist nicht telezentrisch ausgelegt, der bildseitige Hauptstrahlwinkel wächst mit dem objektseitigem Einfallswinkel, welcher über die Systembrennweite mit der Bildfeldkoordinate korreliert ist.

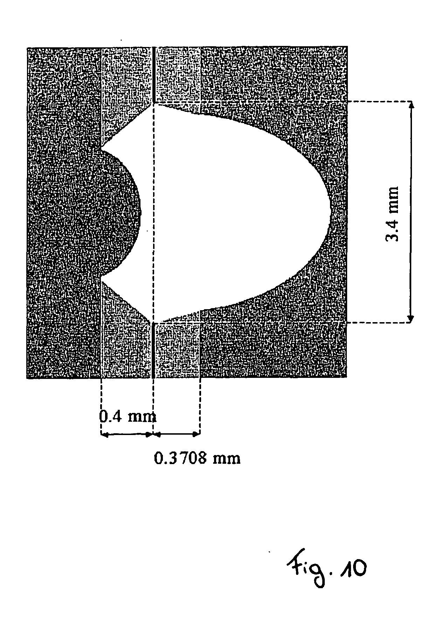

Fig. 10 zeigt den Übergang von Linsenplatte 2 zu Linsenplatte 3 zur Minimierung von Falschlicht auf dem Detektor resultierend von Lichtquellen außerhalb des Gesichtsfeldes. Ausgehend von den Parametern der Linsenplatten resultierend aus dem Optikdesign nach Fig. 5 müssen die Linsenplatten so modifiziert werden, dass sie Abstandshalterungen beinhalten, ohne jedoch auf die optischen Eigenschaften Einfluss zu nehmen, Falschlicht zu generieren und den lateralen Platzbedarf des Objektivs aufgrund großer freier Öffnungen unnötig zu erhöhen. Unter "Abstandshalterungen beinhalten" ist zu verstehen, dass die tatsächlichen optisch relevanten Linsenflächen entsprechend in der Tiefe in den Linsenplatten versenkt bzw. versetzt sind.

### Beispiel

Die Baulänge des in den Figuren dargestellten beschriebenen Objektives mit VGA-Auflösung (640x480) und 5,6 µm Pixelgröße bei einem horizontalen Gesichtsfeld (FOV) von 56° ist 4,32 mm, was für eine derartige Spezifikation gegenüber dem Stand der Technik das kürzeste bekannte optische System darstellt. Die entsprechenden Parameter sind in Tabelle 1 dargestellt.

**Tabelle 1**

| **Parameter** | **Spezifikation** |
|---|---|
| Totale Länge des optischen Systems (erste Fläche bis Bildebene) | 4,32 mm |
| F/# | 2,8 |
| Brennweite | 3,37 mm |
| Durchmesser des Bildkreises | 4,56 mm |
| Nutzbarer Wellenlängenbereich | 450 nm - 630 nm |
| FOV (volle Diagonale) | 70° |
| Objektabstand | 500 mm - unendlich |

### Aufbau der beschriebenen Ausführungsvariante:

Das abbildende System (Fig. 5) besteht aus drei asphärischen Linsenplatten in PMMA 1, 2 und 3 und einer 500 µm dicken Quarz-Glas-Platte 4. Diese dient als thermisch und mechanisch belastbare Trägerstruktur für einen IR-Sperrfilter auf der Vorderseite 4a und einen abgedünnten und rückseitig beleuchteten CMOS-Sensor auf der Rückseite 4b.

Die beiden ersten Linsen im Strahlengang in Richtung des Lichteinfalls 1 und 2 sind asphärisch plankonvex und dienen als geteilte Objektivlinse. Die Systemöffnung (STOP) mit einem Durchmesser von 1,11 mm befindet sich auf der planen Rückseite 1b der ersten Linsenplatte 1. Die Symmetrie der Objektivlinsen um die Systemapertur führt zu verringerten Aberrationen. Die F/# des Systems ist 2.8. Der STOP wird als zusätzliche dünne absorbierende Polymerplatte 5 (schwarzes PMMA) zwischen den Linsenplatten 1 und 2 realisiert. Dabei diente 5 gleichzeitig als abstandsdefinierende Struktur für den Abstand der Linsenplatten 1 und 2 und durch eine geeignete konische Apertur als eine Art Lichtschutztrichter zur Einschränkung des Gesichtsfeldes der Optik und damit zur Reduktion von Streulicht.

Die dritte Linsenplatte 3 ist asphärisch plankonkav und dient als das Bildfeld ebnendes Element und durch geeignete Weiterführung der Form der Fläche 3a gleichzeitig zur Definition des Abstandes zur Fläche 2b. Durch die Nutzung dieses das Bildfeld ebnenden Elementes wird es möglich, eine gleichmäßig hohe MTF über das Gesichtsfeld der Optik zu erhalten.

Telezentrie wird nicht angestrebt, um eine minimale Baulänge zu ermöglichen, die Hauptstrahlwinkel im Bildraum (im Material) entsprechen den Einfallswinkeln (Feldwinkeln).

Die beschriebenen optischen Komponenten können als Arraystrukturen im Wafermaßstab durch Heißprägen erzeugt werden. Die Linsenplatten werden mittels UV-härtbarem Kleber miteinander verbunden, wobei die Abstandsdefinitions- und Justierstrukturen direkt in die Linsenplatten bzw. die zusätzliche absorbierende Platte 5 integriert sind. Die dünne Quarz-Glas-Platte 4 wird auf die Rückseite des PMMA-Optikkomponentenstapels 3b geklebt. Dabei ist zu beachten, dass zwischen der Rückseite des PMMA-Optikkomponentenstapels 3b und dem CMOS-Sensor 4b kein Luftspalt existieren darf, da dieser teilweise Totalreflexion durch die vorliegenden hohen Hauptstrahlwinkel im Bildraum zur Folge hätte.

Der dielektrische IR-Sperrfilter kann in die Anordnung nur auf der Vorderseite des Quarz-Glas-Substrates, auf dessen Rückseite sich die bildgebende Elektronik befindet, eingebracht werden, da eine Beschichtung des PMMA mit dem dielektrischen Schichtsystem aufgrund mechanischthermischer Materialrandbedingungen nicht möglich ist. Aus dem Verzicht auf Telezentrie um möglichst kurze Objektive zu erhalten resultieren große Hauptstrahlwinkel im Bildraum und durch die Nähe des Filters zu diesem ein weites Spektrum von Einfallswinkeln, für die der Filter die Spezifikationen erfüllen muss, um den Weißabgleich des Systems zu ermöglichen. Dieser Fakt und die Tatsache, dass das Superstrat des Filters nicht Luft, sondern PMMA ist, stellen gesteigerte Anforderungen an das Filterdesign. Speziell eine Verschiebung der cut-off Wellenlänge zu kürzeren Wellenlängen bei Vergrößerung des Einfallswinkels beeinflusst die Filtercharakteristik negativ. Deshalb wird ein Filter eingesetzt, der direkt für ein weites Einfallswinkelspektrum, PMMA als Superstrat und die gegebenen Wellenlängenbereiche optimiert wurde. Durch ein spezielles Design eines SiO₂/TiO₂-Schichtsystems wurde es möglich diese Verschiebung der cut-off Wellenlänge für ein Spektrum von Einfallswinkeln von 0-35° innerhalb des Polymers auf 30 nm zu verringern. Fig. 6 zeigt die entsprechende Transmissionskurve des entwickelten Filters für das beschriebene Einfallswinkelspektrum. Die cut-off Wellenlänge (50%) liegt abhängig vom Einfallswinkel zwischen 650 und 675 nm. Die durchschnittliche Transmission im Sperrbereich liegt unter 3% während die Transmission im transparenten Bereich größer 85% ist.

Oberflächenparameter der beschriebenen Ausführungsvariante (Tabelle 2):

**Tabelle 2**

| Fläche | Typ | Radius | Dicke | Material | Durchmesser | Conic | Coeff r^6 |
|---|---|---|---|---|---|---|---|
| OBJEKT | STAND | Infinity | 500 | AIR | 701.5498 | 0 | |
| 1a | ASPH | 2.593351 | 0.63004 | PMMA | 1.661869 | | -1.681042 |
| 1b(STO) | STAND | Infinity | 0.72105 | AIR | 1.108201 | | 0 |
| 2a | STAND | Infinity | 0.84714 | PMMA | 1.937082 | | 0 |
| 2b | ASPH | -1.786246 | 1.31797 | AIR | 2.285339 | 0.4358701 | 0.039834853 |
| 3a | ASPH | -1.08162 | 0.3 | PMMA | 2.70883 | -0.852709 | |
| 3b | STAND | Infinity | 0 | - | 2.70883 | 0 | |
| 4a | STAND | Infinity | 0.5 | SILICA | 4.079017 | 0 | |
| 4b | STAND | Infinity | | SILICA | 4.66547 | 0 | |

Brechzahldaten der beschriebenen Ausführungsvariante (Tabelle 3):

**Tabelle 3**

| | | | | | | |
|---|---|---|---|---|---|---|
| Komponente | Material | Temp | Druck | 0.450000 | 0.535000 | 0.630000 |
| Objekt (Luft) | | 20.00 | 1.0 | 1.00000000 | 1.00000000 | 1.00000000 |
| 1 | PMMA | 20.00 | 1.0 | 1.50102493 | 1.49442296 | 1.49007866 |
| Luftspalt | | 20.00 | 1.0 | 1.00000000 | 1.00000000 | 1.00000000 |
| 2 | PMMA | 20.00 | 1.0 | 1.50102493 | 1.49442296 | 1.49007866 |
| Luftspalt | | 20.00 | 1.0 | 1.00000000 | 1.00000000 | 1.00000000 |
| 3 | PMMA | 20.00 | 1.0 | 1.50102493 | 1.49442296 | 1.49007866 |
| 4 | SILICA | 20.00 | 1.0 | 1.46556566 | 1.46056852 | 1.45709969 |

Eine Achromatisierung ist für die beschriebene Ausführungsvariante nicht nötig, da nur gering dispersives Material (PMMA) eingesetzt wird.

Die Abbildungseigenschaften der beschriebenen Ausführungsvariante sind in den Figuren 7, 8 und 9 wiedergegeben. Die beschriebene Ausführungsvariante hat eine nahezu gleichbleibend hohe MTF über das gesamte Bildfeld und minimale Verzeichnung. Die Hauptstrahlwinkel in der Bildebene entsprechen den jeweiligen Einfallswinkeln.

Das beschriebene Design ist zusätzlich tolerant gegenüber +/- 50 µm Defokussierung, was eine vereinfachte und unkritische axiale Justierung des Optikwaferstapels zu der bildgebenden Elektronik bedeutet (10%ige Vergrößerung des RMS-Spotdurchmessers).
Die Toleranzen des Systems sind unkritisch, da die Hauptstrahlen für alle Feldwinkel nur relativ geringe Winkel zu den Oberflächennormalen der Flächen der optischen Elemente haben.
Skalierungen der Länge der Ausführungsvariante mit Skalierung der Pixelgröße und damit Bildfeldgröße müssen berücksichtigen, dass eine zusätzliche Reduktion der F/# nötig ist, um die beugungsbedingte Auflösungsgrenze an die Pixelgröße anzupassen und die detektierte Lichtleistung beizubehalten.

Zur Vermeidung von Falschlicht auf dem Detektor ausgehend von Quellen außerhalb des Gesichtsfeldes des Objektives wurde erstens eine Systemapertur 5 von großer Dicke und konusförmigem Verlauf gewählt (Fig. 2), die gleichzeitig als Abstandshalter der Linsenplatten 1 und 2 dient und zweitens die freie Öffnung des Überganges zwischen den Linsenplatten 2 und 3 auf 3,4 mm erhöht (Fig. 10). Der Winkel des Konus der Blendenplatte 5 ist so gewählt, dass Lichtbündel ausgehend von Objektpunkten innerhalb des Gesichtsfelds Objektives, welche durch die Systemapertur eintreten nicht vignettiert werden. Bündel, die jedoch von Lichtquellen außerhalb des Gesichtsfeldes ausgehen, werden hingegen teilweise bis komplett vignettiert. Die nur teilweise vignettierten Bündel sind kritisch für die Generation von Falschlicht durch Reflexion oder Brechung an folgenden Grenzflächen, weswegen eine Vergrößerung der freien Öffnung an den folgenden Linsenplattenübergängen soweit erfolgt, dass selbst Licht, welches unter dem größtmöglichen Einfallswinkeln in die Systemöffnung einfällt, nicht an Kanten außerhalb der Linsenöffnungen reflektiert, oder wieder zum Sensor hin gebrochen wird.
Durch ein solches falschlichtsensitives Systemdesign speziell mit der Systemapertur innerhalb des Objektives und nicht als erstes Element, wie bei herkömmlichen Mobiltelefonkameras, und mit einer großen Dicke und nicht nur als dünne Blende, wirkt die Blendenplatte 5 gleichzeitig als Feldblende. Dadurch kann auf Lichtschutztrichter, welche bei heutigen Kameras für Mobiltelefone der eigentlichen Optik zur Feldbegrenzung vorgeschaltet werden müssen und die gesamte Baulänge der Kamera deutlich erhöhen, verzichtet werden.

## Patentansprüche

1. Kameramodul mit einem miniaturisierten Objektiv mit einer Trägerstruktur (4) aus Quarzglas und/oder Pyrex, IR-Sperrfilter (4a) und bildfeldseitig in Wafer-Technologie aufgebrachter bildgebender Optoelektronik (4b) sowie mindestens zwei monolithischen, asphärisch plankonvexen, gesichtsfeldseitigen Linsen (1, 2) aus einem polymeren Werkstoff,
**dadurch gekennzeichnet, dass** das System bildseitig nicht telezentrisch ausgelegt ist, dass eine weitere, asphärisch plankonkave, Linse (3) bildfeldseitig der mindestens zwei Linsen angeordnet ist und zwischen den zwei gesichtsfeldseitigen Linsen (1, 2) ein abstands-definierendes Element (5) in Form einer nicht-transparenten Polymerplatte mit einer die Systemapertur bildenden kegelförmigen Ausnehmung angeordnet ist, die aufgrund ihrer Dicke gleichzeitig als Feldblende wirkt, und dass der IR-Sperrfilter aus einem dielektrischen Schichtsystem besteht und gesichtsfeldseitig in Wafertechnologie auf die Trägerstruktur (4) aufgebracht ist.

2. Kameramodul nach Anspruch 1,
**dadurch gekennzeichnet, dass** die bildgebende Elektronik aus einem CMOS-Sensor besteht.

3. Kameramodul nach dem vorhergehenden Anspruch,
**dadurch gekennzeichnet, dass** der CMOS-Sensor rückseitig abgedünnt und beleuchtet ist.

4. Kameramodul nach Anspruch 1,
**dadurch gekennzeichnet, dass** die bildgebende Elektronik aus einem CCD-Sensor besteht.

5. Kameramodul nach einem der vorhergehenden Ansprüche,
**dadurch gekennzeichnet, dass** mindestens eine Linse (1, 2, 3) aus einem Polymer ausgewählt aus der Gruppe bestehend aus Polymethylmethacrylat, Polycarbonat, Polystyrol, Cycloolefin-Polymer, Cycloolefin-Copolymer oder anderen Polymeren auf Polycycloolefin-Basis besteht.

6. Kameramodul nach einem der vorhergehenden Ansprüche,
**dadurch gekennzeichnet, dass** die mindestens zwei Linsen (1, 2) unterschiedliche Dispersionscharakteristika aufweisen und damit die Achromatisierung des Objektivs ein gestellt ist.

7. Kameramodul nach einem der vorhergehenden Ansprüche,
**dadurch gekennzeichnet, dass** mindestens eine Linse (1, 2, 3) dielektrisch und/oder durch Mottenaugenstukturen ein- oder beidseitig entspiegelt ist.

8. Kameramodul nach einem der vorhergehenden Ansprüche,
**dadurch gekennzeichnet, dass** die gesichtsfeldseitige Linse (1) gesichtsfeldseitig eine feuchtigkeitsabweisende Beschichtung aufweist.

9. Kameramodul nach einem der vorhergehenden Ansprüche,
**dadurch gekennzeichnet, dass** die gesichtsfeldseitige Linse (1) gesichtsfeldseitig eine kratzfeste Beschichtung aufweist.

10. Kameramodul nach einem der vorhergehenden Ansprüche,
**dadurch gekennzeichnet, dass** die gesichtsfeldseitige Linse (1) gesichtsfeldseitig eine entspiegelnde Beschichtung, insbesondere durch Mottenaugenstrukturen, aufweist.

11. Kameramodul nach einem der vorhergehenden Ansprüche,
**dadurch gekennzeichnet, dass** die Baulänge des Kameramoduls von der Bildebene bis zur ersten Oberfläche des Kameramoduls im Bereich zwischen 1 mm und 10 mm, insbesondere 3 mm und 5 mm liegt.

12. Array aus Kameramodulen nach einem der der vorhergehenden Ansprüche,
**dadurch gekennzeichnet, dass** die Kameramodule auf einer einzigen Trägerstruktur (4) und die Linsen auf zwei Linsenplatten (1, 2) angeordnet sind und die Kameramodule einen Waferstapel bilden.

13. Array aus Kameramodulen nach Anspruch 12,
**dadurch gekennzeichnet, dass** zwischen 2 und mehrere tausend Kameramodule auf der Trägerstruktur (4) angeordnet sind.

14. Verfahren zur Herstellung eines Kameramoduls nach einem der Ansprüche 1 bis 11 im Wafermaßstab, **dadurch gekennzeichnet, dass** bild-feldseitig die bildgebende Elektronik (4b) und gesichtsfeldseitig der IR-Sperrfilter (4a) aus einem dielektrischen Schichtsystem auf der Trägerstruktur (4) aus Quarz und/oder Pyrex in Wafertechnologie aufgebracht wird, mindestens zwei durch Heißprägung oder UV-Replikation hergestellte Polymer-Linsenplatten mit einem UV- oder thermisch härtbarem Klebstoff untereinander über ein abstandsdefinierendes Element (5) in Form einer nicht-transparenten Polymerplatte und gesichtsfeldseitig mit dem IR-Sperrfilter verbunden werden und die einzelnen Kameramodule mittels Sägeblättern separiert werden.

15. Verfahren nach Anspruch 14,
**dadurch gekennzeichnet, dass** Justierstrukturen zur Erhöhung der Präzision bei der Montage des Waferstapels verwendet werden.

16. Verfahren nach einem der Ansprüche 14 der 15,
**dadurch gekennzeichnet, dass** das abstandsdefinierende Element (5) durch Heißprägen, Spritzgießen oder Ausbohren aus einer nicht-transparenten Polymerplatte hergestellt wird.

17. Verfahren nach einem der Ansprüche 14 bis 16,
**dadurch gekennzeichnet, dass** die gesichtfeldseitige Seite der gesichtfeldseitigen Linsenplatte (1) mit einer feuchtigkeitsabweisenden Beschichtung versehen ist.

18. Verfahren nach einem der Ansprüche 14 bis 17
**dadurch gekennzeichnet, dass** die gesichtfeldseitige Seite der gesichtfeldseitigen Linsenplatte (1) mit einer kratzfesten Beschichtung versehen ist.

19. Verfahren nach einem der Ansprüche 14 bis 18,
**dadurch gekennzeichnet, dass** mindestens eine Linsenplatte (1, 2, 3) eine dielektrische Beschichtung aufweist.

20. Verfahren nach einem der Ansprüche 14 bis 19,
**dadurch gekennzeichnet, dass** mindestens eine Linsenplatte (1, 2, 3) mit einer entspiegelnden Beschichtung, insbesondere mit einer Mottenaugenstruktur versehen ist.

21. Verfahren nach einem der Ansprüche 14 bis 20,
**dadurch gekennzeichnet, dass** nach der Separation der einzelnen Kameramodule die Seiten der separierten Kameramodule zur Minimierung von Streulicht geschwärzt werden.

22. Verwendung des Kameramoduls nach einem der Ansprüche 1 bis 11 zur Herstellung von Mobiltelefonen oder tragbaren Minicomputern.

## Claims

1. Camera module having a miniaturised objective with a support structure (4) made of quartz glass and/or Pyrex, having an IR barrier filter (4a) and on the image field side, applied by wafer technology, an image-producing optoelectronic unit (4b), and also at least two monolithic, aspherical plano-convex optical lenses (1, 2) on the visual field side, made of a polymer material,
**characterised in that** the system is not designed for telecentrical use on the image side, that a further asperical plano-concave Lens (3) is disposed on the image field side of the at least two lenses (1, 2) and between the two lenses on the visual field side (1, 2), a spacing-defining element (5) in the form of a non-transparent polymer plate having a conical recess which forms the system aperture is disposed, said recess acting as field diaphragm due to the thickness thereof, and that the IR barrier filter consists of a dielectric layer system and is applied on visual field side on the support structure (4) by wafer technology.

2. Camera module according to claim 1, **characterised in that** the image-producing electronic unit consists of a CMOS sensor.

3. Camera module according to the preceding claim, **characterised in that** the CMOS sensor is thinned and illuminated at the rear.

4. Camera module according to claim 1, **characterised in that** the image-producing electronic unit consists of a CCD sensor.

5. Camera module according to one of the preceding claims, **characterised in that** at least one lens (1, 2, 3) consists of a polymer selected from the group consisting of polymethylmethacrylate, polycarbonate, polystyrene, cycloolefin polymer, cycloolefin copolymer or other polymers on a polycycloolefin basis.

6. Camera module according to one of the preceding claims, **characterised in that** the at least two lenses (1, 2) have different dispersion characteristics and hence the achromatisation of the objective is adjusted.

7. Camera module according to one of the preceding claims, **characterised in that** the at least one lens (1, 2, 3) is anti-reflective on one or both sides dielectrically and/or due to moth eye structures.

8. Camera module according to one of the preceding claims, **characterised in that** the lens on the visual field side (1) has a moisture-repellent coating on the visual field side.

9. Camera module according to one of the preceding claims, **characterised in that** the lens on the visual field side (1) has a scratch-resistant coating on the visual field side.

10. Camera module according to one of the preceding claims, **characterised in that** the lens on the visual field side (1) has an anti-reflective coating, in particular due to moth eye structures, on the visual field side.

11. Camera module according to one of the preceding claims, **characterised in that** the constructional length of the camera module from the image plane to the first surface of the camera module is in the range between 1 mm and 10 mm, in particular 3 mm and 5 mm.

12. Array of camera modules according to one of the preceding claims, **characterised in that** the camera modules are disposed on a single support structure (4) and the lenses are disposed on two lens plates (1, 2) and the camera modules form a wafer stack.

13. Array of camera modules according to claim 12, **characterised in that** between 2 and several thousand camera modules are disposed on the support structure.

14. Method for producing a camera module according to one of the claims 1 to 11 on wafer scale, **characterised in that**, on the image field side, the image-producing electronic unit (4b) and, on the visual field side, the IR barrier filter (4a) consisting of a dielectric layer system is applied on a support structure (4) made of quartz and/or Pyrex by wafer technology, at least two polymer lens plates produced by hot stamping or UV replication are connected to each other by a UV or thermally curable adhesive via a spacing-defining element (5) in the form of a non-transparent polymer plate and, on the visual field side, connected to the IR barrier filter (4a), and the individual camera modules are separated by means of saw blades.

15. Method according to claim 14, **characterised in that** adjustment structures are used to increase the precision during assembly of the wafer stack.

16. Method according to one of the claims 14 or 15, **characterised in that** the spacing-defining element (5) is produced by hot stamping, injection moulding or boring out of a non-transparent polymer plate.

17. Method according to one of the claims 14 to 16, **characterised in that** the visual field-side side of the visual field-side lens plate (1) is provided with a moisture-repellent coating.

18. Method according to one of the claims 14 to 17, **characterised in that** the visual field-side side of the visual field-side lens plate (1) is provided with a scratch-resistant coating.

19. Method according to one of the claims 14 to 18, **characterised in that** the at least one lens plate (1, 2, 3) has a dielectric coating.

20. Method according to one of the claims 14 to 19, **characterized in that** at least one lens plate (1, 2, 3) is provided with an anti-reflective coating, in particular with a moth eye structure.

21. Method according to one of the claims 14 to 20, **characterised in that**, after separation of the individual camera modules, the sides of the separated camera modules are blackened in order to minimize scattered light.

22. Use of the camera module according to one of claims 1 to 11 for producing mobile telephones or portable minicomputers.

## Revendications

1. Module de caméra doté d'un objectif miniaturisé, avec une structure porteuse (4) en verre de quartz et/ou en Pyrex, un filtre suppresseur d'infrarouges (4a) et, du côté champ d'image, une unité d'imagerie optoélectronique (4b) apposée en technologie de plaquettes, et avec, du côté champ de vision, au moins deux lentilles asphériques plan-convexes monolithiques (1, 2) en un matériau polymère,
**caractérisé en ce que** le système n'est pas conçu de manière télécentrique côté image, **en ce qu'**une lentille supplémentaire, asphérique plan-concave (3) est agencée du côté champ d'image des au moins deux lentilles, et entre les deux lentilles (1, 2) situées du côté champ de vision est agencé un élément (5) définissant l'écartement et se présentant sous la forme d'une plaque de polymère non transparente et pourvue d'un évidement conique formant l'ouverture du système, plaque de polymère qui en raison de son épaisseur joue en même temps le rôle de diaphragme de champ, et **en ce que** le filtre suppresseur d'infrarouges est constitué d'un système stratifié diélectrique et est apposé en technologie de plaquettes sur la structure porteuse (4) du côté champ de vision.

2. Module de caméra selon la revendication 1, **caractérisé en ce que** l'unité d'imagerie électronique est constituée d'un capteur CMOS.

3. Module de caméra selon la revendication précédente, **caractérisé en ce que** le capteur CMOS est aminci et éclairé du côté arrière.

4. Module de caméra selon la revendication 1, **caractérisé en ce que** l'unité d'imagerie électronique est constituée d'un capteur à transfert de charge (CCD).

5. Module de caméra selon l'une des revendications précédentes, **caractérisé en ce qu'**au moins une lentille (1, 2, 3) est constituée d'un polymère sélectionné dans le groupe constitué du polyméthacrylate de méthyle, du polycarbonate, du polystyrène, du polymère cyclooléfinique, du copolymère cyclooléfinique ou d'autres polymères à base de polycyclooléfine.

6. Module de caméra selon l'une des revendications précédentes, **caractérisé en ce que** les au moins deux lentilles (1, 2) présentent des caractéristiques de dispersion différentes, réglant ainsi l'achromatisation de l'objectif.

7. Module de caméra selon l'une des revendications précédentes, **caractérisé en ce qu'**au moins une lentille (1, 2, 3) est traitée antireflet d'un ou des deux côtés, de manière diélectrique et/ou par des structures en yeux de mite.

8. Module de caméra selon l'une des revendications précédentes, **caractérisé en ce que** la lentille (1) située du côté champ de vision présente, du côté champ de vision, un revêtement repoussant l'humidité.

9. Module de caméra selon l'une des revendications précédentes, **caractérisé en ce que** la lentille (1) située du côté champ de vision présente, du côté champ de vision, un revêtement antirayures.

10. Module de caméra selon l'une des revendications précédentes, **caractérisé en ce que** la lentille (1) située du côté champ de vision présente, du côté champ de vision, un revêtement antireflet, en particulier par des structures en yeux de mite.

11. Module de caméra selon l'une des revendications précédentes, **caractérisé en ce que** la longueur hors tout du module de caméra depuis le plan d'image jusqu'à la première surface du module de caméra se situe dans la plage entre 1 mm et 10 mm, en particulier entre 3 mm et 5 mm.

12. Réseau de modules de caméra selon l'une des revendications précédentes, **caractérisé en ce que** les modules de caméra sont agencés sur une unique structure porteuse (4) et les lentilles sur deux plaques de lentille (1, 2), et les modules de caméra forment une pile de plaquettes.

13. Réseau de modules de caméra selon la revendication 12, **caractérisé en ce qu'**entre 2 et plusieurs milliers de modules de caméra sont agencés sur la structure porteuse (4).

14. Procédé de fabrication d'un module de caméra selon l'une des revendications 1 à 11 à l'échelle des plaquettes, **caractérisé en ce que** sont apposés en technologie de plaquettes, sur la structure porteuse (4) en quartz et/ou en Pyrex, du côté champ d'image l'unité d'imagerie électronique (4b) et du côté champ de vision le filtre suppresseur d'infrarouges (4a) constitué d'un système stratifié diélectrique, sont assemblées, à l'aide d'une colle durcissable aux UV ou à la chaleur, au moins deux plaques de lentille polymères fabriquées par estampage à chaud ou par réplication aux UV, entre elles via un élément (5) définissant l'écartement sous la forme d'une plaque de polymère non transparente, et du côté champ de vision au filtre suppresseur d'infrarouges, et sont séparés les modules de caméra individuels au moyen de lames de scie.

15. Procédé selon la revendication 14, **caractérisé en ce que** des structures d'ajustement sont utilisées lors du montage de la pile de plaquettes, afin d'augmenter la précision.

16. Procédé selon l'une des revendications 14 ou 15, **caractérisé en ce que** l'élément (5) définissant l'écartement est fabriqué à partir d'une plaque de polymère non transparente par estampage à chaud, moulage par injection ou alésage.

17. Procédé selon l'une des revendications 14 à 16, **caractérisé en ce que** le côté champ de vision de la plaque de lentille (1) située du côté champ de vision est pourvu d'un revêtement repoussant l'humidité.

18. Procédé selon l'une des revendications 14 à 17, **caractérisé en ce que** le côté champ de vision de la plaque de lentille (1) située du côté champ de vision est pourvu d'un revêtement antirayures.

19. Procédé selon l'une des revendications 14 à 18, **caractérisé en ce qu'**au moins une plaque de lentille (1, 2, 3) présente un revêtement diélectrique.

20. Procédé selon l'une des revendications 14 à 19, **caractérisé en ce qu'**au moins une plaque de lentille (1, 2, 3) est pourvue d'un revêtement antireflet, en particulier d'une structure en yeux de mite.

21. Procédé selon l'une des revendications 14 à 20, **caractérisé en ce qu'**à la suite de la séparation des modules de caméra individuels, les côtés des modules de caméra séparés sont noircis afin de minimiser la lumière diffusée.

22. Utilisation du module de caméra selon l'une des revendications 1 à 11 pour la fabrication de téléphones mobiles ou de mini-ordinateurs portables.
